# FASCICULE DE BREVET EUROPEEN

(11) **EP 0 558 702 B1**
(45) Date de publication et mention de la délivrance du brevet: **01.05.1996**
(21) Numéro de dépôt: 92916945.6
(22) Date de dépôt: 14.08.1992
(51) Int. Cl.: G01R 15/18, G01R 15/20

(54) **CAPTEUR DE COURANT AVEC CIRCUIT MAGNETIQUE A ENTREFER**
Stromsensor mit Magnetkern mit Luftspalte
CURRENT SENSOR HAVING A MAGNETIC CIRCUIT WITH AN AIR GAP

(30) Priorité: 20.09.1991 CH 2789/91
(43) Date de publication de la demande: 08.09.1993
(73) Titulaire: LIAISONS ELECTRONIQUES-MECANIQUES LEM S.A., CH-1228 Plan-les-Ouates (CH)
(72) Inventeur: ETTER, Marcel, CH-1256 Troinex (CH)
(74) Mandataire: Hranitzky, Wilhelm Max
(86) Numéro de dépôt international: CH9200163
(87) Numéro de publication internationale: WO9306491

(56) Documents cités:
- FR-A- 737 490
- FR-A- 2 331 029
- US-A- 3 284 710

## Description

La présente invention concerne un capteur de courant électrique comportant un circuit magnétique à entrefer et au moins une bobine électrique disposée autour d'une branche de ce circuit, cette branche ayant une forme de parallélépipède rectangle allongée. Plus particulièrement, l'invention s'applique à des capteurs du type susmentionné à boucle ouverte dans lesquels un générateur de Hall est disposé dans l'entrefer du circuit magnétique.

Les présents capteurs, dont le circuit magnétique présente un seul entrefer, nécessitent deux pièces séparées ou des empilages de deux groupes de pièces de tôle pour permettre le montage d'une bobine sur une branche du circuit magnétique. Une telle structure et le procédé de montage qui en découle, sont coûteux et rendent les installations de montage automatique relativement complexes, le problème majeur étant la réalisation d'un enchevêtrement des pièces de tôle lors de l'assemblage des circuits magnétiques lamellaires usuels.

L'invention vise à fournir un capteur de courant d'un prix de revient nettement inférieur à celui des capteurs actuels du même type, et à permettre notamment un montage beaucoup plus simple de la ou des bobines sur le circuit magnétique.

A cet effet, le capteur de courant selon l'invention est caractérisé en ce que le circuit magnétique est constitué par une seule pièce, ou par un empilage correspondant de tôles de même forme, et présente un entrefer s'étendant parallèlement à la branche sur laquelle est disposée ladite bobine, la hauteur de cet entrefer étant plus grande que l'épaisseur de la bobine mesurée transversalement à la direction longitudinale de ladite branche, d'un côté de celle-ci, de façon à permettre la mise en place de la bobine en la faisant passer par l'entrefer.

Le capteur selon l'invention peut notamment comporter un bobinage auto-portant ou un bobinage réalisé sur un support isolant ayant, au moins sur la longueur supportant le bobinage, une section transversale en forme de U, le côté ouvert du U étant orienté vers l'intérieur du circuit magnétique. Dans ce cas, le support comporte, de préférence, à au moins une de ses extrémités, un flasque dont une portion, située du côté ouvert du U de la partie du support portant le bobinage, possède une hauteur inférieure à celle de l'entrefer. Cette portion du flasque peut notamment posséder une hauteur plus faible du côté tourné vers l'extérieur du support que du côté tourné vers le bobinage.

Selon la présente invention, la bobine peut être placée sur un support isolant séparé, lui-même placé autour de ladite branche du circuit, ce support ayant au moins sur un côté de sa section transversale une épaisseur inférieure à la hauteur de l'entrefer, de façon à permettre sa mise en place à l'intérieur de la bobine en le faisant passer par l'entrefer.

Au moins une deuxième bobine peut être disposée à l'intérieur d'une première bobine, cette deuxième bobine ayant une épaisseur, mesurée transversalement à la direction longitudinale de ladite branche de circuit d'un côté de celle-ci, inférieure à la hauteur de l'entrefer, de façon à permettre la mise en place de cette deuxième bobine sur ladite branche de circuit en la faisant passer par l'entrefer après l'introduction de la première bobine.

De préférence, l'entrefer est formé entre une partie latérale d'une extrémité libre de la branche du circuit magnétique portant la ou les bobines, et une partie frontale d'une extrémité libre d'une branche de circuit essentiellement perpendiculaire à la branche portant la ou les bobine(s). Dans ce cas, la branche perpendiculaire à celle portant la ou les bobine(s) peut comporter une extrémité de section transversale plus grande que les sections des autres parties du circuit.

Selon une forme d'exécution particulière, une pièce ou un empilage de tôles en un matériau magnétiquement perméable est disposée en contact avec des parties du circuit voisines de l'entrefer, de façon à constituer un pont magnétique sur l'entrefer.

L'invention sera mieux comprise à la lumière de la description suivante de différentes formes d'exécution, indiquées à titre d'exemple et illustrées dans le dessin annexé, dans lequel:
La Fig. 1 est une vue latérale d'un circuit magnétique à entrefer muni d'une bobine, pour un capteur selon l'invention;
La Fig. 2 est une vue de front du circuit de la Fig. 1;
La Fig. 3 est une coupe transversale d'un circuit magnétique similaire muni de deux bobines superposées;
La Fig. 4 est une vue partielle du circuit magnétique de la Fig. 3;
La Fig. 5 est une vue latérale, partiellement en coupe, d'un support de bobine utilisable dans l'agencement de la Fig. 3;
La Fig. 6 est une vue frontale, partiellement en coupe, selon la ligne VI-VI de la Fig. 5;
La Fig. 7 est un détail illustrant une variante du support de la Fig. 5;
la Fig. 8 est une vue partielle similaire à celle de la Fig. 6, pour la variante selon la Fig. 7;
La Fig. 9 est une vue latérale d'un circuit magnétique portant deux bobines sur des branches différentes; et
La Fig. 10 est une vue en coupe, selon la ligne X-X de la Fig. 9.

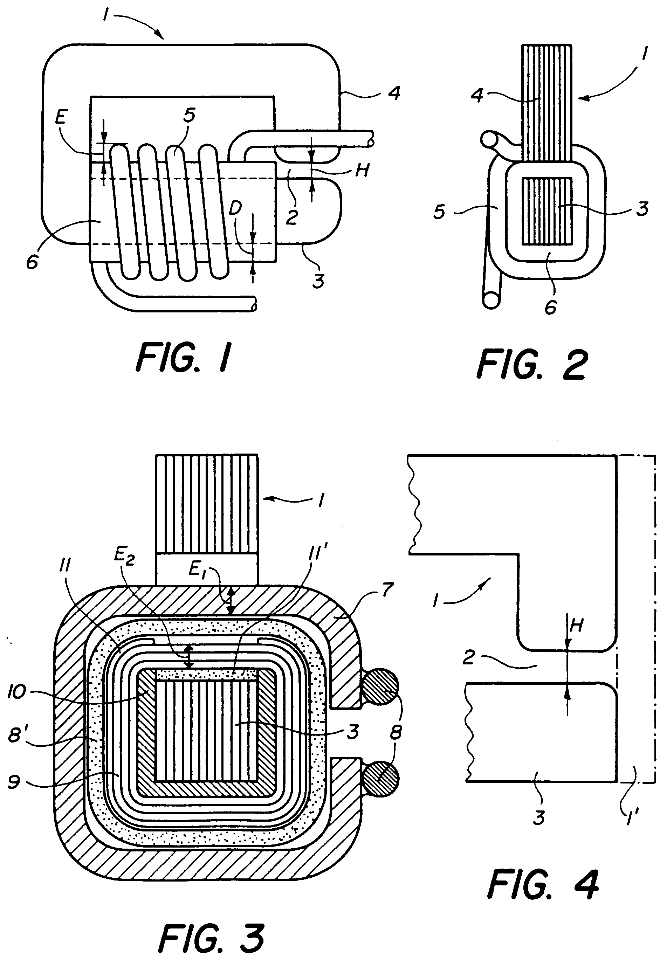

La Fig. 1 montre un circuit magnétique 1 présentant un entrefer 2, formé entre la partie latérale de l'extrémité d'une branche 3 du circuit et la partie frontale d'une extrémité libre d'une branche 4 perpendiculaire à la branche 3. La hauteur H de l'entrefer 2 est légèrement supérieure à l'épaisseur E d'une bobine 5 et à l'épaisseur D d'un support isolant tubulaire 6. Le circuit magnétique peut être réalisé en une pièce de ferrite ou, comme l'illustre la Fig. 2, par un empilage de pièces de tôle, de même forme, assemblé pour former un tel circuit.

La hauteur de l'entrefer H permet d'introduire la bobine 5 à travers cet entrefer, puis, dans une deuxième étape, d'introduire le support 6 à l'intérieur de cette bobine en l'enfilant sur la branche 3.

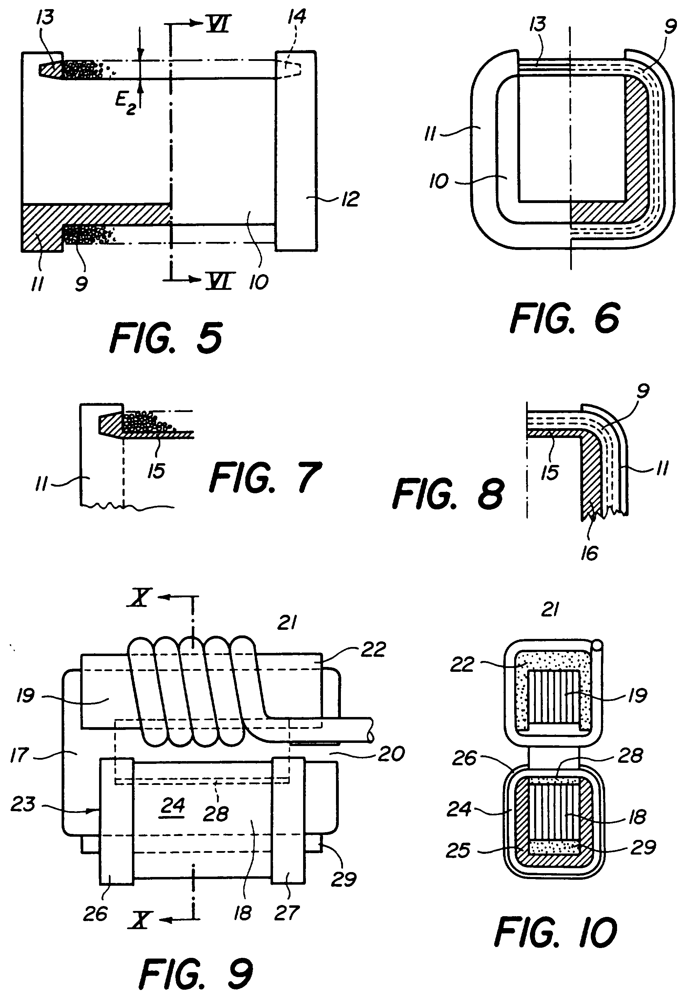

La Fig. 3 illustre le cas où deux enroulements sont superposés sur la branche 3 d'un circuit magnétique similaire à celui de la Fig. 1 et représenté partiellement à la Fig. 4. Un premier enroulement 7 est constitué, par exemple, par une spire plate unique 7, à laquelle sont soudés des fils de connexion 8. La spire 7 possède une épaisseur E1 inférieure à la hauteur H de l'entrefer 2 du circuit 3, et sera introduite en premier à travers cet entrefer. Puis, un tube isolant 8', dont les dimensions extérieures sont légèrement inférieures aux dimensions intérieures de la spire 7, est introduit de façon similaire et disposé à l'intérieur de la spire 7.

Un enroulement 9 réalisé sur un support isolant 10 est ensuite également introduit à travers l'entrefer 2 et placé à l'intérieur du tube isolant 8. Le corps du support 10, qui porte l'enroulement 9, présente une section transversale en forme de U dont la partie ouverte est orientée vers l'intérieur du circuit 1. Ceci permet de donner à l'enroulement 9 une épaisseur maximale correspondant à la hauteur H de l'entrefer, puisque le support ne contribue pas à la hauteur totale de la bobine 9, 10 sur la partie devant passer à travers l'entrefer 2. Enfin, une cale 11' est introduite, entre la branche 3 du circuit et l'enroulement 9 à l'endroit de l'ouverture du U du support 10, pour isoler l'enroulement de la branche 3. Cette cale 11' est également introduite par l'entrefer.

La Fig. 4 montre en outre schématiquement une pièce 1' magnétiquement perméable qui peut être disposée en contact avec les parties du circuit 1 voisines de l'entrefer 2, afin de former un pont ou shunt magnétique sur l'entrefer pour améliorer les performances dynamiques du capteur, plus particulièrement dans le cas d'un capteur du type à compensation. Une autre forme d'exécution du circuit prévoit à cet effet de conférer au moins à l'extrémité de la branche en regard de la branche 3 une section transversale plus grande que celle du reste du circuit.

Les Fig. 5 et 6 montrent la bobine 9,10 de la Fig. 3, l'enroulement 9 n'étant indiqué que partiellement et le support 10 étant représenté partiellement en coupe. Les deux extrémités du support 10 sont constituées par des flasques 11, 12 qui présentent à l'endroit d'une portion respective 13, 14 une section réduite dont la hauteur correspond à l'épaisseur E2 du bobinage 9. Les portions 13, 14 correspondent à la largeur intérieure du corps en forme de U du support 10 et sont destinées à passer par l'entrefer 2 au moment de la mise en place de la bobine. Pour faciliter l'insertion de l'ensemble par l'entrefer, la section des portions 13, 14 peut être trapézoïdale comme l'illustrent les Fig. 5 et 6.

Les Fig. 7 et 8 illustrent une variante d'exécution du support 10 selon laquelle une paroi d'isolation 15 fait partie du corps d'un support 16, cette paroi ayant une épaisseur faible de manière à ne réduire que de peu l'épaisseur maximale E2 du bobinage. Dans ce cas, une cale telle que 11' n'est généralement plus nécessaire.

Les Fig. 9 et 10 illustrent une forme d'exécution dans laquelle un circuit magnétique 17 est formé par un empilage de tôles en forme de C. Deux bobines sont disposées respectivement sur des branches parallèles 18 et 19 de ce circuit, leur mise en place s'effectuant d'une façon similaire aux exemples précédents en passant par l'entrefer 20 de ce circuit. Telle que montrée à titre d'exemple, une bobine 21 à fil épais est disposée sur un support isolant 22 qui en l'occurence présente une section transversale en forme de U et peut être insérée entre la bobine et la branche 19 de l'extérieur du circuit. Une bobine 23 comporte un bobinage 24 réalisé sur support 25 dont le corps portant le bobinage présente également une forme de U ouvert vers l'intérieur du circuit. Des flasques 26, 27 sont découpées de manière à permettre le passage de la bobine par l'entrefer 20 avec une épaisseur du bobinage légèrement inférieure à la hauteur de l'entrefer. Une pièce intermédiaire isolante 28 peut être disposée au préalable sur la branche 18 de façon que le bobinage 24 ne vienne pas en contact avec cette branche lorsque la bobine a été mise en place. En outre, une cale 29 est introduite entre la branche 18 et le support 25 de l'extérieur du circuit.

Les exemples susmentionnés sont bien entendu nullement limitatifs et de nombreuses autres formes et variantes d'exécution sont du domaine de l'homme de métier.

## Revendications

1. Capteur de courant électrique comportant un circuit magnétique (1) à entrefer (2) et au moins une bobine électrique (5,9) disposée autour d'une branche (3) de ce circuit, cette branche ayant une forme de parallélépipède rectangle allongé, caractérisé en ce que le circuit magnétique (1) est constitué par une seule pièce, ou par un empilage correspondant de tôles de même forme, et présente un entrefer (2) s'étendant parallèlement à la branche (3) sur laquelle est disposée ladite bobine (5,9), la hauteur (H) de cet entrefer (2) étant plus grande que l'épaisseur (E) de la bobine (5,9) mesurée transversalement à la direction longitudinale de ladite branche (3), d'un côté de celle-ci, de façon à permettre la mise en place de la bobine en la faisant passer par l'entrefer (2).

2. Capteur selon la revendication 1, caractérisé en ce que la bobine (5) comporte un bobinage autoportant.

3. Capteur selon la revendication 1, caractérisé en ce que la bobine (9) comporte un bobinage réalisé sur un support isolant (10) ayant, au moins sur la longueur supportant le bobinage, une section transversale en forme de U, le côté ouvert du U étant orienté vers l'intérieur du circuit magnétique (1).

4. Capteur selon la revendication 3, caractérisé en ce que le support (10) comporte, à au moins une de ses extrémités, un flasque (11) dont une portion située du côté ouvert du U de la partie du support portant le bobinage possède une hauteur inférieure à celle de l'entrefer.

5. Capteur selon la revendication 4, caractérisé en ce que ladite portion du flasque (11) possède une hauteur plus faible du côté tourné vers l'extérieur du support que du côté tourné vers le bobinage.

6. Capteur selon la revendication 1, caractérisé en ce que la bobine (5) est placée sur un support isolant (6) séparé, lui-même placé autour de ladite branche (3) du circuit, ce support (6) ayant, au moins sur un côté de sa section transversale, une épaisseur (D) inférieure à la hauteur (H) de l'entrefer (2), de façon à permettre sa mise en place à l'intérieur de la bobine, en le faisant passer par l'entrefer.

7. Capteur selon l'une des revendications précédentes, caractérisé en ce qu'au moins une deuxième bobine (9) est disposée à l'intérieur d'une première bobine (7), cette deuxième bobine (9) ayant une épaisseur (E₂), mesurée transversalement à la direction longitudinale de ladite branche du circuit d'un côté de celle-ci, inférieure à la hauteur (H) de l'entrefer (2), de façon à permettre la mise en place de cette deuxième bobine sur ladite branche du circuit en la faisant passer par l'entrefer après l'introduction de la première bobine.

8. Capteur selon l'une des revendications précédentes, caractérisé en ce que l'entrefer (2) est formé entre une partie latérale d'une extrémité libre de la branche (3) du circuit magnétique portant la ou les bobines, et une partie frontale d'une extrémité libre d'une branche (4) de circuit essentiellement perpendiculaire à la branche portant la ou les bobines.

9. Capteur selon la revendication 8, caractérisé en ce que ladite branche (4) perpendiculaire à celle portant la ou les bobines, comporte une extrémité de section transversale plus grande que les sections des autres parties du circuit.

10. Capteur selon l'une des revendications précédentes, caractérisé en ce qu'une pièce ou un empilage de tôles en un matériau magnétiquement perméable est disposé en contact avec des parties du circuit voisines de l'entrefer, de façon à constituer un pont magnétique sur l'entrefer (2).

## Patentansprüche

1. Elektrischer Stromsensor, der einen magnetischen Kreis (1) mit einem Luftspalt (2) und mindestens eine um einen Arm (3) dieses Kreises herum angeordnete elektrische Spule (5, 9) aufweist, wobei dieser Arm die Form eines rechtwinkligen langgestreckten Parallelepipedes besitzt, dadurch gekennzeichnet, dass der magnetische Kreis (1) aus einem einzigen Stück oder aus einem entsprechenden Stapel von Blechen der gleichen Form besteht und einen Luftspalt (2) aufweist, der parallel zu dem Arm (3), auf dem die genannte Spule (5, 9) angeordnet ist, verläuft, wobei die Höhe (H) dieses Luftspalts (2) grösser ist als die Dicke (E) der Spule (5, 9), quer zur Längsrichtung des genannten Armes (3) auf einer Seite desselben gemessen, derart, dass es möglich ist, die Spule in ihre Stellung zu bringen, indem sie durch den Luftspalt (2) hindurchgeführt wird.

2. Sensor nach Patentanspruch 1, dadurch gekennzeichnet, dass die Spule (5) eine selbsttragende Wicklung aufweist.

3. Sensor nach Patentanspruch 1, dadurch gekennzeichnet, dass die Spule (9) eine auf einem isolierenden Träger (10) aufgebrachte Wicklung aufweist, die mindestens über die die Wicklung tragende Länge einen U-förmigen Querschnitt besitzt, wobei die offene Seite des U gegen das Innere des Magnetkreises (1) gerichtet ist.

4. Sensor nach Patentanspruch 3, dadurch gekennzeichnet, dass der Träger (10) an mindestens einem seiner Enden einen Flansch (11) aufweist, wobei ein Teil desselben, der auf der offenen Seite des U des die Wicklung tragenden Trägerteils liegt, eine geringere Höhe als die Höhe des Luftspalts besitzt.

5. Sensor nach Patentanspruch 4, dadurch gekennzeichnet, dass der genannte Teil des Flansches (11) eine geringere Höhe auf der nach aussen gerichteten Seite des Trägers als auf der der Wicklung zugewandten Seite besitzt.

6. Sensor nach Patentanspruch 1, dadurch gekennzeichnet, dass die Spule (5) auf einem getrennten isolierenden Träger (6) angeordnet ist, der selbst um den genannten Arm (3) des Kreises herum angeordnet ist, wobei dieser Träger (6) zumindest auf der Seite seines Querschnitts eine Dicke (D) besitzt, die kleiner als die Höhe (H) des Luftspalts (2) ist, derart, dass es möglich ist, ihn in seine Stellung im Inneren der Spule zu bringen, indem man ihn durch den Luftspalt hindurchführt.

7. Sensor nach einem der vorhergehenden Patentansprüche, dadurch gekennzeichnet, dass mindestens eine zweite Spule (9) im Innern einer ersten Spule (7) angeordnet ist, wobei diese zweite Spule (9) eine Dicke (E₂), quer zur Längsrichtung des genannten Armes des Kreises auf der einen Seite desselben gemessen, besitzt, die kleiner ist als die Höhe (H) des Luftspalts (2), derart, dass diese zweite Spule auf dem genannten Arm des Kreises in ihre Stellung gebracht werden kann, indem man sie nach der Einführung der ersten Spule durch den Luftspalt hindurchführt.

8. Sensor nach einem der vorhergehenden Patentansprüche, dadurch gekennzeichnet, dass der Luftspalt (2) zwischen einem seitlichen Teil eines freien Endes des Armes (3) des Magnetkreises, welcher die Spule oder die Spulen trägt, und einem Stirnteil eines freien Endes eines Armes (4) des Kreises, der im wesentlichen senkrecht zu dem die Spule oder die Spulen tragenden Arm verläuft, gebildet wird.

9. Sensor nach Patentanspruch 8, dadurch gekennzeichnet, dass der genannte, senkrecht zu dem die Spule oder die Spulen tragenden Arm verlaufende Arm (4) ein Ende mit einem grösseren Querschnitt als die Querschnitte der anderen Teile des Kreises besitzt.

10. Sensor nach einem der vorhergehenden Patentansprüche, dadurch gekennzeichnet, dass ein Stück oder ein Stapel von Blechen aus einem magnetisch permeablen Material in Berührung mit Teilen des Kreises angeordnet ist, die in der Nähe des Luftspalts liegen, so dass eine magnetische Überbrückung des Luftspalts (2) gebildet wird.

## Claims

1. An electric current sensor comprising a magnetic circuit (1) with an air-gap (2) and at least one electric coil (5, 9) arranged around a branch (3) of this circuit, this branch having the shape of an elongate rectangular parallelepiped, characterized in that the magnetic circuit (1) consists of a single piece or of a stacking of metal sheets of same shape and has an air-gap (2) extending parallely to the branch (3) on which said coil (5, 9) is arranged, the height (H) of this air-gap (2) being greater than the thickness (E) of the coil (5, 9), measured transversally to the longitudinal direction of said branch (3) on one side thereof, so as to allow the positioning of the coil by passing it through the air-gap (2).

2. A sensor according to claim 1, characterized in that the coil (5) comprises a self-supporting winding.

3. A sensor according to claim 1, characterized in that the coil (9) comprises a winding formed on an insulating support (10) having, at least over the length supporting the winding, a U-shaped cross-section, the open side of the U being directed towards the inside of the magnetic circuit (1).

4. A sensor according to claim 3, characterized in that the support (10) comprises, at least at one of its ends, a flange (11), a portion of which, located on the open side of the U of the support part carrying the winding, has a height lesser than that of the air-gap.

5. A sensor according to claim 4, characterized in that said portion of the flange (11) has a smaller height on the side directed outwards of the support than on the side directed towards the winding.

6. A sensor according to claim 1, characterized in that the coil (5) is placed on a separate insulating support (6) which is itself arranged around said branch (3) of the circuit, this support (6) having at least on one side of its cross-section a smaller thickness (D) than the height (H) of the air-gap (2) so as to allow its positioning inside the coil by passing it through the air-gap.

7. A sensor according to one of the preceding claims, characterized in that at least a second coil (9) is arranged inside a first coil (9), this second coil (9) having a thickness (E₂), measured transversally to the longitudinal direction of said branch of the circuit on one side thereof, which is smaller than the height (H) of the air-gap (2) so as to allow the positioning of this second coil on said branch of the circuit by passing it through the air-gap after the introduction of the first coil.

8. A sensor according to one of the preceding claims, characterized in that the air-gap (2) is formed between a side part of a free end of the branch (3) of the magnetic circuit bearing the coil or the coils and a front part of a free end of a branch (4) of the circuit substantially perpendicular to the branch bearing the coil or the coils.

9. A sensor according to claim 8, characterized in that said branch (4), perpendicular to the branch bearing the coil or the coils, comprises an end having a cross-section greater than the sections of the other parts of the circuit.

10. A sensor according to one of the preceding claims, characterized in that a piece or a stacking of sheets of a magnetically permeable material is placed in contact with the parts of the circuit adjacent to the air-gap so as to form a magnetic bridge across the air-gap (2).
